Europäisches Patentamt

European Patent Office

Office européen des brevets

(11) Publication number: **0 598 356 A2**

# EUROPEAN PATENT APPLICATION

(21) Application number: **93118355.2**

(22) Date of filing: **12.11.93**

(51) Int. Cl.5: **G01R 15/07**, G01R 33/032

(30) Priority: **16.11.92 JP 305407/92**
**20.11.92 JP 312200/92**

(43) Date of publication of application:
**25.05.94 Bulletin 94/21**

(84) Designated Contracting States:
**DE FR GB**

(71) Applicant: **MATSUSHITA ELECTRIC INDUSTRIAL CO., LTD.**
**1006, Oaza Kadoma**
**Kadoma-shi, Osaka-fu, 571(JP)**

(72) Inventor: **Hamada, Hidenobu**
**41-202, Higashi sakuragi-cho**
**Amagasaki-shi, Hyogo(JP)**

(74) Representative: **Eisenführ, Speiser & Partner**
**Martinistrasse 24**
**D-28195 Bremen (DE)**

(54) **Polarization state detector and current sensor using it.**

(57) The objective of the present invention is to provide a current sensor that does not depend on the frequency of a current to be measured.

A current sensor of the present invention is composed by arranging along the optic axis, successively from the side of incident light, a first polarizer, a Faraday cell for detection, a Faraday cell for modulation, and a second polarizer. A magnetic field proportional to a current to be measured is impressed on the Faraday cell for detection, and a periodic magnetic field for modulation that varies the angle of Faraday rotation by $n\pi$ radians, where n is a positive integer, during each period and that has a frequency higher than the magnetic field impressed on the Faraday cell for detection is impressed on the Faraday cell for modulation, and the current to be measured is determined based on a phase change in the intensity of the light emitted from the second polarizer of said polarization state detector.

A current to be measured is determined accurately from DC to high frequency without being influenced by the external environment.

Fig.1

## BACKGROUND OF THE INVENTION

### 1. Field of the Invention

The present invention relates to a polarization detector that analyzes the state of polarization of an arbitrary light beam and its temporal changes under control by a magnetic field and a current sensor that, using the polarization state detector, detects a rotating magnetic field generated around a distribution line or a wire for a driving current of a motor or the like to determine the current flowing through the distribution line or the wire; the current sensor can be used for an optical current transformer.

### 2. Description of the Related Art

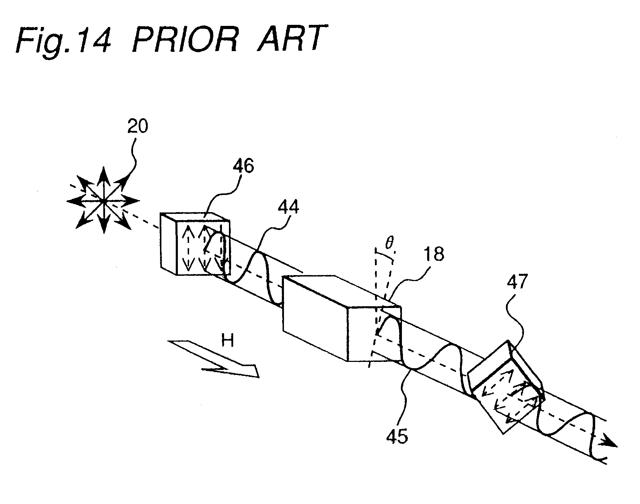

As shown in Fig. 14, an intensity-modulated current sensor arranges along an optical axis, successively from the side of incident light, a polarizer 46 of set angle 90 degrees, a Faraday cell 18, and a polarizer 47 of set angle 45 degrees, and a magnetic field H proportional to a current to be measured is applied to Faraday cell 18. Since the change in the output intensity of the second polarizer 47 depends on the angle of the Faraday rotation $\theta$, the current to be measured can be determined by monitoring the change in the output intensity of polarizer 47 with an optical receiver. Here, the modulation depth of an output power is defined as the ratio of the AC component of the output power to the DC component of the same.

However, a change in the loss of connection in each optical part and a change in the intensity of the incident light due to the external environment generate a gradual change in the output power apart from the above modulation of the output power due to the current to be measured. In particular, if the frequency of the current to be measured is near DC, it becomes impossible to distinguish the AC component of the current to be measured from the AC component due to the above secondary causes, so that exact measurement can not be achieved.

## SUMMARY OF THE INVENTION

The object of the present invention is therefore to solve the problem described above in a prior intensity-modulated current sensor and to provide a current sensor that performs the measurement from DC to high-frequency AC with its simple composition and without being influenced by the external environment.

In order to achieve the aforementioned objective, the present invention provides a polarization state detector composed by arranging along an optical axis, successively from the side of incident light, a modulating Faraday cell, a polarizer, and an optical receiver. The Faraday cell is controlled by a periodic magnetic field so that one complete Faraday rotation can be made around the optical axis. The polarizer is set in a base direction for analyzing the polarization state of the incident light. The optical receiver sends a signal of the received light level to a signal analyzer that analyzes the polarization state of the incident light at any time. The signal analyzer analyzes the polarization state of the incident light based on the difference between the set angle of the polarizer and the angle of the Faraday rotation and the level of received light. The present invention also provides a current sensor composed by arranging along the optical axis, successively from the incident light side of the above polarization state detector, a first polarizer and a Faraday cell for detecting the current to be measured. A magnetic field proportional to the current to be measured is applied to the Faraday cell for detection. A periodic magnetic field for modulation that varies the angle of Faraday rotation by $n\pi$ radians, where n is a positive integer during each period and that has a frequency higher than that of the magnetic field applied to the Faraday cell for detection is applied to the Faraday cell for modulation in the above polarization state detector. The current sensor then detects the current to be measured from the phase change in the intensity of the light emitted from the polarizer of the polarization state detector.

By using the above current sensor, the current to be measured is determined for a wide range from DC to high frequency without being influenced by the external environment.

## BRIEF DESCRIPTION OF THE DRAWINGS

These and other objects and features of the present invention will become clear from the following description taken in conjunction with the preferred embodiments thereof with reference to the accompanying drawings throughout which like parts are designated by like reference numerals and in which:

Fig. 1 is a diagram of a polarization state detector of a first embodiment in accordance with the present invention;

Figs. 2 and 3 show graphs of the changes in the intensity of the magnetic field used for controlling the polarization state detector of the first embodiment;

Fig. 4 is a diagram of an output-power-phase-modulated current sensor of a second embodiment in accordance with the present invention;

Fig. 5 is a block diagram showing the phase-modulated current sensor shown in Fig. 4;

Figs. 6, 7 and 8 show graphs of the changes of I, Im and P, respectively;

Fig. 9 is a diagram of an output-power-frequency-modulated current sensor of a third embodiment in accordance with the present invention;

Fig. 10 shows the waveform of an output P of the polarizer shown in Fig. 9;

Figs. 11 and 12 show examples of the waveform of a periodic current for modulation used in a current sensor of the present invention, respectively;

Fig. 13 is a front view of the current sensor of the present invention which is cross-sectioned along a longitudinal center line thereof, and;

Fig. 14 is a diagram of a prior intensity-modulated current sensor used for measuring current.

## DETAILED DESCRIPTION OF THE PREFERRED EMBODIMENTS

The preferred embodiments according to the present invention will be described below with reference to the attached drawings.

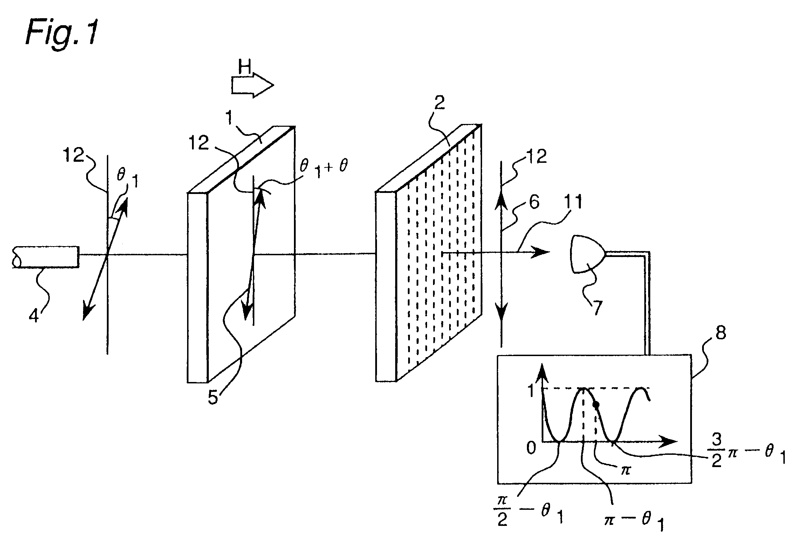

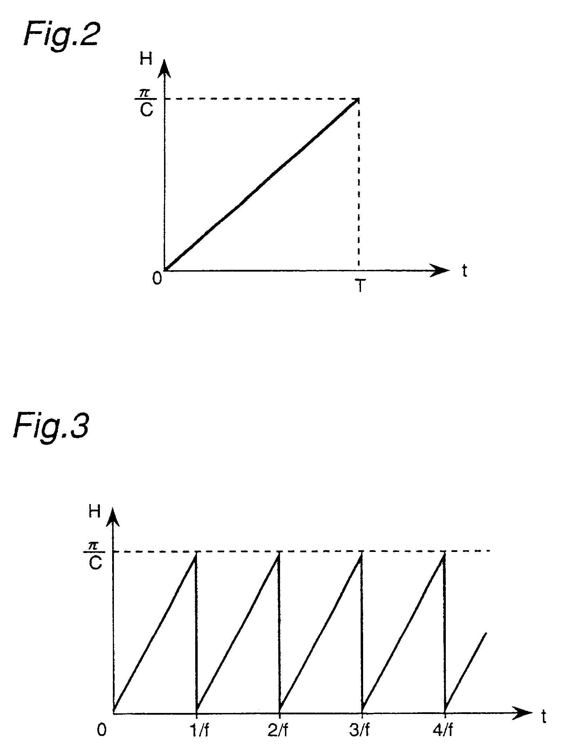

Fig. 1 shows a diagram of a polarization state detector of a first embodiment, and Figs. 2 and 3 show the graphs of changes in the intensity of a magnetic field to be applied. The polarization state detector comprises a Faraday cell 1 made of a magneto-optical crystal such as (BiYGd)IG, a polarizer 2, and an optical receiver 7 successively arranged in this order from the side of incident light along the optical axis 11. Faraday cell 1 is controlled by an external magnetic field H so that its direction of rotation (angle of rotation $\theta$) can be varied all over one complete rotation around the optical axis. Polarizer 2 is set to a base direction for analyzing the polarization state, that is, to the vertical 12 in the present invention. Optical receiver 7 receives linearly polarized light 6 that has passed through polarizer 2 to send a signal of the received level of light at any time to a signal analyzer 8 for analyzing the polarization state. Signal analyzer 8 analyzes the polarization state of the incident light based on the relation between the difference between the angle $\theta$ of Faraday rotation and the set angle of the polarizer and the received level of light. Here the sign of the direction of rotation around the optical axis is defined as positive, if the observer is looking in the direction the light is traveling, and the rotation is counter-clockwise. The angle is measured in units of radians.

Next, the theory is described. For example, as shown in Fig. 1, suppose incident light 4 transmitted through an optical fiber is linearly polarized light inclined by $\theta_1$ 9 from set direction 12 of polarizer 2. Then the light that has passed through Faraday cell 1 becomes linearly polarized light 5 having inclination $\theta_1 + \theta$ from set direction 12 of polarizer 2. Further, light 6 that has passed through polarizer 2 after emitted from Faraday cell 1 shows a change of intensity proportional to $\{\cos2(\theta_1 + \theta) + 1\} \div 2$ from the intensity of the incident light. This value is shown in signal analyzer 8 for analyzing the polarization state in Fig. 1 by a graphical representation, where the abscissa is $\theta$. In particular, a minimum change in the intensity of the received light is obtained, when the plane of polarization of incident light 4 is changed to be perpendicular to the set angle of polarizer 2 by Faraday rotation. A maximum change is obtained, when the plane of polarization is changed to be parallel to the set angle. In general, by analyzing the change in the intensity of the received light, it is found that incident light is linearly polarized light inclined by $\theta_1$.

In case incident light 4 is any elliptically polarized light, the output intensity of polarizer 2 of a polarization state detector in accordance with the present invention shows an intensity change proportional to $\{\cos2\beta \cdot \cos2(\theta_2 + \theta) + 1\} \div 2$ for elliptically polarized light having the angle of the major axis $\theta_2$ and the angle of ellipticity $\beta$ (if $\beta = 0$, then the light is linearly polarized with polarization angle $\theta_2$). Therefore, the angle of the major axis $\theta_2$ and the angle of ellipticity $\beta$ are measured based on the change in the light intensity received by optical receiver 7. Specifically, first the angle of the major axis $\theta_2$ is determined by angle $\theta$ of Faraday rotation for which the above output intensity is maximum, or the angle of the minor axis, which is perpendicular to the major axis, is determined by angle $\theta$ of Faraday rotation for which the above output intensity is minimum. Then the angle of ellipticity $\beta$ is determined by the extreme values.

As seen from the above description, since the polarization state is point symmetric with respect to the optic axis, if angle $\theta$ of Faraday rotation is varied by $\pi/2$, then either a maximum or minimum value of the intensity of the received light can be observed, so that the polarization state of the incident light is determined.

Next, the external magnetic field that controls angle $\theta$ of Faraday rotation is described with reference to Figs. 2 and 3.

First, consider the case where a temporal change of the polarization state is not analyzed, or a constant polarization state is detected. If a magnetic field proportional to time as shown in Fig. 2 is used as external magnetic field 3 controlling angle $\theta$ of Faraday rotation, then signal analyzer 8 for analyzing the polarization state can determine the polarization state of the incident light by analyzing the temporal change in the intensity of the received light. Here, the magnitude of the applied magnetic field may be varied so that the change in the angle $\theta$ of Faraday rotation is made a little over $\pi/2$.

However, if $\theta$ is changed by about $\pi$ as shown in Fig. 2, so that both maximum and minimum values of the intensity of the received light are observed, then the angle $\theta_2$ of the major axis is obtained with more precision.

Next, the case where a temporal change of the polarization state of incident light 4 is analyzed is described. In this case, a magnetic field of a sawtooth waveform shown in Fig. 3, which is obtained from repeating the one shown in Figure 2 with a carrier frequency f, is used as external magnetic field 3 controlling angle $\theta$ of Faraday rotation. The polarization state of the incident light 4 is analyzed at a scanning period of 1/f ( = T), and sampling frequency f is varied depending on the velocity of a change in the polarization state of incident light 4. For example, if the polarization state of incident light 4 is varying with a frequency of 60 Hz, then sampling frequency f is set to about 1 kHZ.

Next, a current sensor using the above polarization state detector is described.

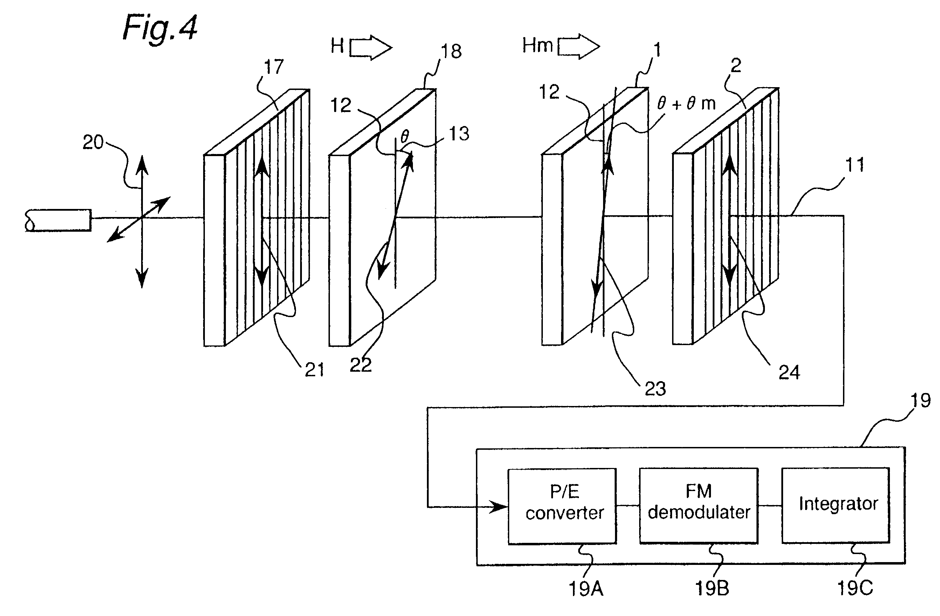

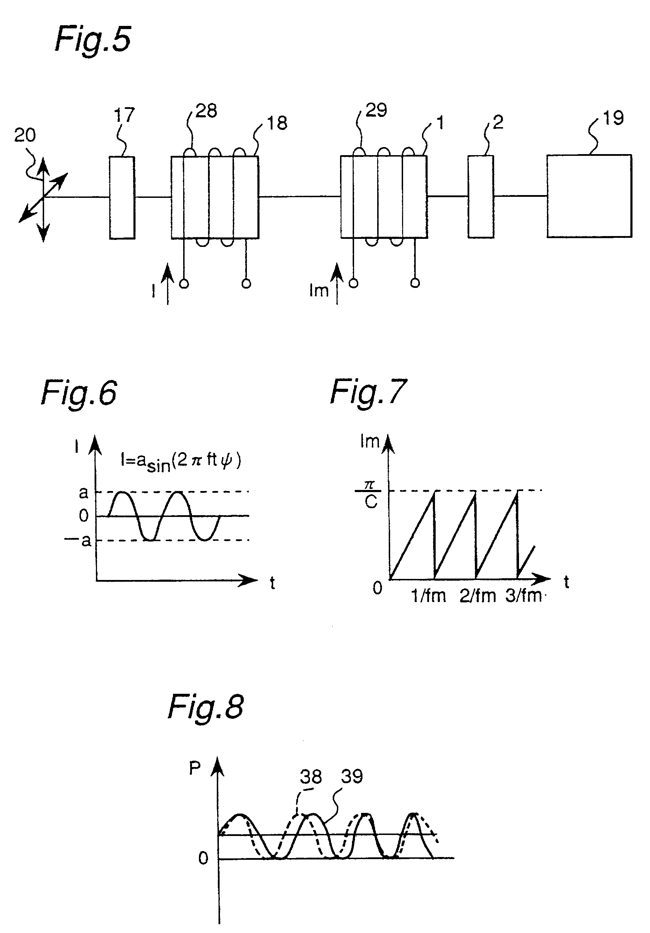

Fig. 4 shows a diagram of a current sensor of a second embodiment, and Fig. 5 and Figs. 6 to 8 show a diagram and graphs for describing the operation of the second embodiment, respectively. The current sensor comprises the above polarization state detector and a first polarizer 17 and a Faraday cell 18 for detecting the current to be measured arranged in this order along optical axis 11, successively from the incident light side of the above polarization state detector. The angle of first polarizer 17 is set to be parallel to the angle of polarizer 2 of the polarization state analyzer, and Faraday cell 18 is set in an arbitrary direction. A magnetic field for detection H proportional to a current to be measured (current to be detected) is applied to Faraday cell 18 for detection. A periodic magnetic field $H_m$ for modulation that varies the angle $\theta_m$ of Faraday rotation by $n\pi$ radians, where n is a positive integer, during each period and that has a frequency much higher than that of magnetic field H applied to Faraday cell 18 for detection is impressed on Faraday cell 1 for modulation of the above polarization state detector. The angle of polarizer 2 of the polarization state detector is set to the vertical.

Next, the theory is described. Unpolarized incident light 20 is changed by first polarizer 17 into linearly polarized light 21, which after passing through Faraday cell 18 for detection becomes linearly polarized light 22, which is inclined by angle $\theta$ of Faraday rotation for detection from set direction 12 of the first polarizer, where $\theta$ is proportional to magnetic field H for detection. After passing through Faraday cell 1 for modulation the light becomes linearly polarized light 23 inclined from set angle 12 of the polarizers by $\theta + \theta_m$, which is

the sum of angle $\theta$ of Faraday rotation for detection and angle $\theta_m$ of Faraday rotation for modulation, where $\theta_m$ is proportional to magnetic field $H_m$. Further, linearly polarized light 24 that has passed through polarizer 2 of the polarizing state detector shows a change of intensity proportional to $\{\cos 2(\theta_m + \theta) + 1\} \div 2$ from the intensity of the incident light. Then a signal analyzer 19 for optical calculation compares the phase change $\theta + \theta_m$ of above output 24 with the phase angle $\theta_m$ of Faraday rotation for modulation to calculate the phase difference $\theta$, which is the angle of Faraday rotation for detection, and determines current to be measured. Concretely, the signal analyzer 19 is comprised of a photo-electric converter 19A for converting the light 24 to an electric power proportional to the intensity thereof, FM demodulator 19B connected to the photo-electric converter 19A and an integrator 19C for integrating the output from FM demodulator 19B. Here the sign of the direction of rotation around optical axis 11 is defined as positive, if the observer is looking in the direction the light is traveling, and the rotation is counter-clockwise 13. The angle is measured in units of radians.

Next, the operation of a current sensor of the second embodiment is described with reference to Figs. 5 to 8. Fig. 5 shows a block diagram of the second embodiment. A coil 28 for detection is wound around Faraday cell 18 for detection, and a coil 29 for modulation is wound around Faraday cell 1 for modulation. Magnetic field H for detection is generated by applying current to be measured I, and magnetic field $H_m$ for modulation is generated by applying a current $I_m$ for modulation. Suppose that current to be measured I has a sine waveform of amplitude a, frequency f, and initial phase angle $\phi$ 36, as shown in Fig. 6. Current $I_m$ for modulation has a sawtooth waveform of modulation frequency $f_m$ and varies linearly with slope $\pi \times f_m/C$ during each period of $1/f_m$, as shown in Fig. 7. Here constant C is a proportional coefficient between the current for modulation and the angle of Faraday rotation for modulation. With the application of current to be measured I, output 24 of polarizer 2 of the polarization state detector phase changes from the sine wave corresponding to the variation of angle $\theta_m$ of Faraday rotation for modulation, which is proportional to current I for modulation, by a phase of $\theta$, which is the angle of Faraday rotation for detection proportional to current to be measured I, as shown in Fig. 8. Here the broken curve 38 shows the original sine wave, and the solid curve 39 shows the phase-changed sine wave. Then signal analyzer 19 for optical calculation demodulates current to be measured I proportional to angle $\theta$ of Faraday rotation from the phase change $\theta + \theta_m$ of output 24.

Here, carrier frequency $f_m$ is required to be sufficiently higher than the frequency f of current to be measured. If current to be measured I is of commercial frequency, modulation frequency $f_m$ of about 1 kHz is sufficient.

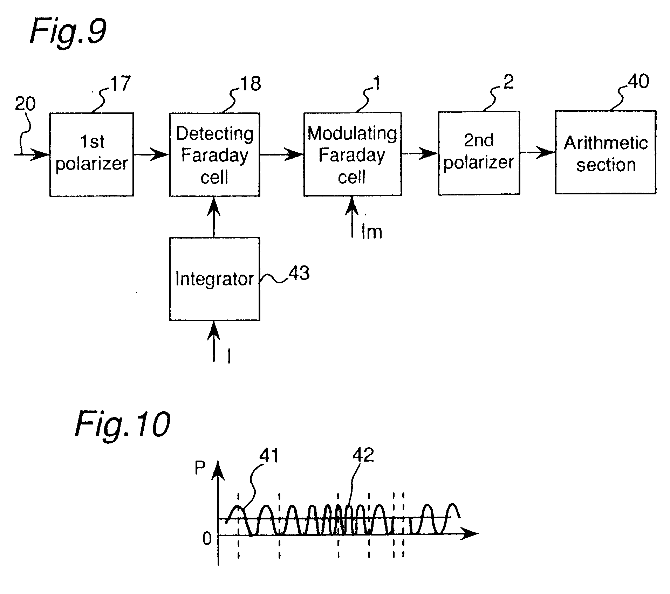

Next, a current sensor of a third embodiment is described with reference to Figs. 9 and 10. As shown in Fig. 9, the third embodiment is the same as the second embodiment in that a first polarizer 17, a Faraday cell 18 for detection, a Faraday cell for modulation 1, and a polarizer 2 of the above polarization state detector are arranged in this order along the optical axis. However, an integrator 43 that inputs current to be measured I to itself and performs an integrating operation to output magnetic field for detection is installed between Faraday cell 18 and current to be measured I. Here, obtaining magnetic field 27 that varies by a change equivalent to the integral value of current to be measured 30 suffices. For example, the input to integrator 43 may be a magnetic field proportional to current to be measured 30. With the application of current to be measured 30, output 24 of polarizer 2 of the polarization state detector frequency changes from a sine wave 41 corresponding to the variation of angle $\theta_m$ of Faraday rotation for modulation, which is proportional to current I for modulation, by an amount proportional to $\theta$, which is the angle of Faraday rotation for detection proportional to current to be measured I, as shown in Fig. 10. The result is a frequency-modulated waveform 32. Then signal analyzer 40 for optical calculation, having a composition same as that of the signal analyzer 19 shown in Fig. 4, demodulates frequency-modulated waveform 32 to obtain current to be measured proportional to angle $\theta$ of Faraday rotation.

Thus, if a current is measured through a phase change or a frequency change in a carrier of modulated light, the measurement can be performed without being influenced by essential problems in dealing with an optical transmission channel such as a change in the loss of connection in an optical part or a change in light intensity due to the external environment. Further, since information other than that of the current to be measured is not mixed with the phase change or the frequency change, consideration of the distinction between the current to be measured and the other external influences in measuring a near DC current through an intensity change by a prior method becomes unnecessary, so that the measurement can be performed by a consistent method for currents from DC to AC.

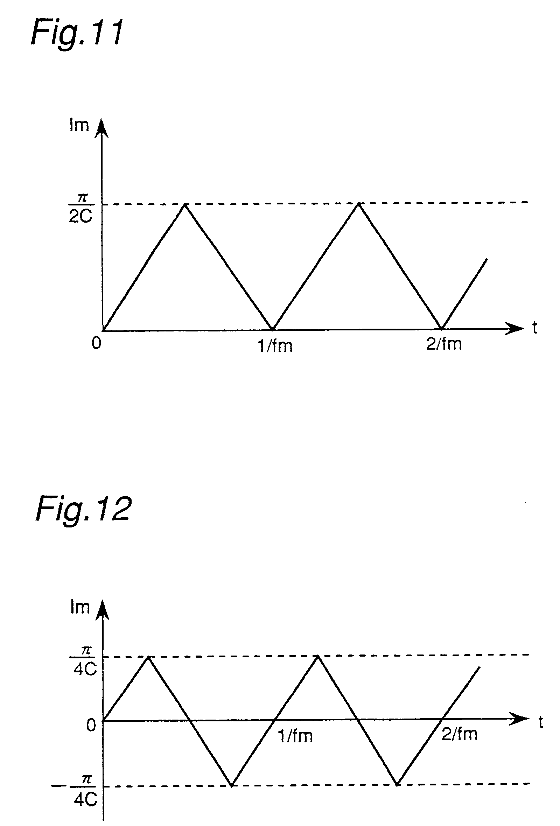

The above description is valid in any case where the directions of first polarizer 17 and polarizer 2 of the above polarization state detector are arbitrary. If the two directions are parallel or perpendicular to each other, then apart from a sawtooth waveform that varies the angle of Faraday rotation by $n\pi$ radians, where n is a positive integer, during each period as shown in Fig. 7, current for modulation $I_m$ that varies the angle of Faraday rotation by $n\pi/2$ from $k\pi/2$ to $(k + n)\pi/2$, where k is an integer including zero, n is a positive integer, suffices, so that current for modulation $I_m$ can be made small. Further, as shown in Fig. 11, the waveform of current for modulation $I_m$ can be made isosceles triangular unlike the sawtooth waveform shown in Fig. 7, where the angle $\theta_m$ of Faraday rotation is varied rapidly in a neighborhood of $n\pi$ radians, so that the turbulence of the output wave occurs less. Here Fig 11 shows the case of k = -1 and n = 1.

Further, if the above two polarization directions make 45 degrees, then the angle of Faraday rotation can be varied from $k\pi/2 + \pi/4$ to $(k + n)\pi/2 + \pi/4$, where k is an integer including zero, n is a positive integer, suffices. In particular, if k = -1 and n = 1, then the positive and negative currents for modulation become symmetric and the load of the power source can be reduced.

Since both the second and third embodiments detect a current using a phase change or temporary phase change (frequency) in the intensity of light, the set angles of first polarizer 17 and second polarizer 2 can be arbitrary, so far as their relative set angles are appropriate. Also, the second and third embodiments arranged Faraday cell 18 for detection and Faraday cell 1 for modulation from the incident side of the light in this order. However, the order may be the opposite.

Finally, if current I to be measured is located in the distance, or if all of first polarizer 17, Faraday cell 18 for detection, Faraday cell 1 for modulation, and polarizer 2 of the polarization state detector can not be arranged in the same optical axis, such as when first polarizer 17 or Faraday cell 1 or polarizer 2 of the polarization state detector is installed in another apparatus, then an optical transmission channel such as a polarization plane preserving fiber where the polarization state is not changed can be used between neighboring devices of first polarizer 17, Faraday cell 18 for detection, Faraday cell 1 for modulation, and polarizer 2 of the polarization state detector such that the distance between them is far or the optic axes differ.

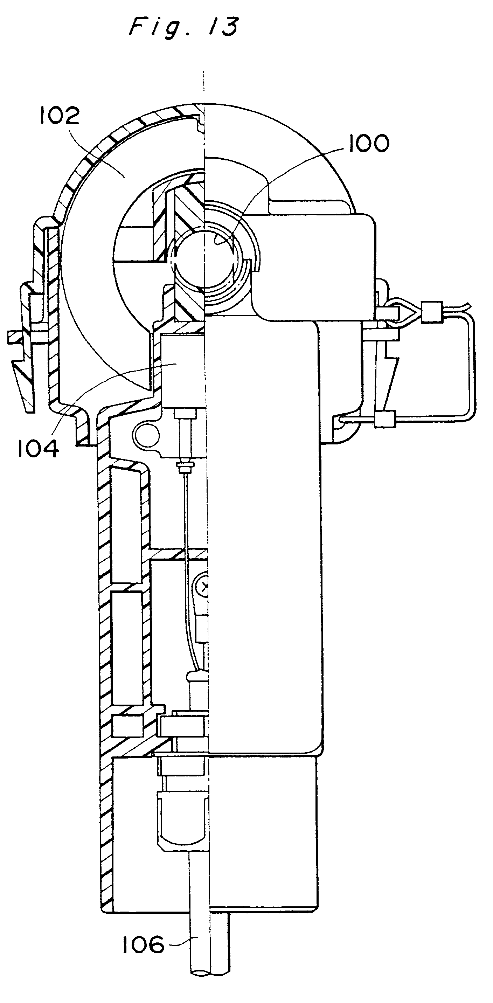

Fig. 13 shows a current sensor unit according to the present invention which is adapted for mounting on an electric cable directly so that a current flowing through the electric cable can be detected at a location remote from the cable.

This unit is mounted on the electric cable using a center hole 100 formed at the head portion thereof. An arch-like magnetic core 102 is arranged in a case so that it surrounds the electric cable and a current sensor module 104 is arranged between free ends of the magnetic core 104 so that a magnetic field generated by a current flowing through the electric cable and trapped by the magnetic core 102 is applied thereto. An incident light from a light source such as LED (not shown) is introduced into this module from an optical fiber cable 106 and an output light having passed through the module 104 is sent through the optical fiber cable 106 to the signal analyzer 19 or 40 (not shown in this figure) to detect the intensity of the current flowing through the cable.

As described above, the present invention has the effect of detecting current and/or voltage to be measured from DC to high frequency exactly without being influenced by the external environment.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. A polarization state detector composed by arranging along the optic axis, successively from the side of incident light, a Faraday cell and a polarizer, the angle of Faraday rotation of said Faraday cell being varied by more than $\pi/2$ radians by an external magnetic field, the polarization state of incident light being analyzed based on a relation between said angle of Faraday rotation and the intensity change in the output light of said polarizer.

2. The polarization state detector as defined in claim 1 wherein said external magnetic field varying the angle of Faraday rotation is periodic, the period is shorter than the time during which the polarization state of the incident light varies, and the variation of the angle of Faraday rotation is performed during a plurality of the periods.

3. The polarization state detector as defined in claim 1 wherein said external magnetic field is a function of time and is impressed on said Faraday cell, and the polarization state of the incident light is analyzed based on the relation between time and the intensity change in the output light.

4. A current sensor composed by arranging along the optic axis, successively from the incident light side of a polarization state detector defined in claim 1, a first polarizer and a first Faraday cell such that a magnetic field approximately proportional to a current to be measured is impressed on said first Faraday cell, a periodic magnetic field for modulation having a frequency higher than the magnetic field impressed on said first Faraday cell is impressed as an external magnetic field on the Faraday cell of said polarization state detector, and the current to be measured is determined based on the phase change in the intensity of the light emitted from the polarizer of said polarization state detector.

5. A current sensor composed by arranging along the optic axis, successively from the incident light side of a polarization state detector defined in claim 1, a first polarizer and a first Faraday cell such that a magnetic field proportional to a current to be measured is impressed on the Faraday cell of said polarization state detector, a periodic magnetic field for modulation having a frequency higher than the magnetic field impressed on the Faraday cell of said polarization state detector is impressed as an external magnetic field on said first Faraday cell, and the current to be measured is determined based on the phase change in the intensity of the light emitted from the polarizer of said polarization state detector.

6. A current sensor composed by arranging along the optic axis, successively from the incident light side of a polarization state detector defined in claim 1, a first polarizer and a first Faraday cell such that a magnetic field proportional to the value obtained by integrating a current to be measured with respect to time is impressed on said first Faraday cell, a periodic magnetic field for modulation having a frequency higher than the magnetic field impressed on said first Faraday cell is impressed as an external magnetic field on the Faraday cell of said polarization state detector, and the current to be measured is determined based on a frequency change in the intensity of the light emitted from the polarizer of said polarization state detector.

7. A current sensor composed by arranging along the optic axis, successively from the incident light side of a polarization state detector defined in claim 1, a first polarizer and a first Faraday cell such that a magnetic field proportional to the value obtained by integrating a current to be measured with respect to time is impressed on the Faraday cell of said polarization state detector, a periodic magnetic field for modulation having a frequency higher than the magnetic field impressed on said first Faraday cell is impressed as an external magnetic field on said first polarizer, and the current to be measured is determined based on a frequency change in the intensity of the light emitted from the polarizer of said polarization state detector.

8. A current sensor selected from the group of current sensors defined in claims 4, 5, 6, and 7 wherein said periodic magnetic field for modulation varies the angle of Faraday rotation by $n\pi$ radians during each period, where n is a positive integer.

9. A current sensor selected from the group of current sensors defined in claims 4, 5, 6, and 7 wherein the polarization directions of said first polarizer and the polarizer of said polarization state detector are set to be parallel to each other, and said periodic magnetic field for modulation varies the angle of Faraday rotation approximately from $k\pi/2$ to $(k + n)\pi/2$ during each period, where k is an integer, n is a positive integer.

10. A current sensor selected from the group of current sensors defined in claims 4, 5, 6, and 7 wherein the polarization directions of said first polarizer and the polarizer of said polarization state detector are set to be perpendicular to each other, and said periodic magnetic field for modulation varies the angle of Faraday rotation approximately from $k\pi/2$ to $(k + n)\pi/2$ during each period, where k is an integer, n is a positive integer.

11. A current sensor selected from the group of current sensors defined in claims 4, 5, 6, and 7 wherein the polarization directions of said first polarizer and the polarizer of said polarization state detector are set to make the angle between them 45 degrees, and said periodic magnetic field for modulation varies the angle of Faraday rotation approximately from $k\pi/2 + \pi/4$ to $(k + n)\pi/2 + \pi/4$ during each period, where k is an integer, n is a positive integer.

12. A current sensor selected from the group of current sensors defined in claims 4, 5, 6, and 7 wherein an optical transmission channel for preserving the polarization plane is used at least between two neighboring devices selected from said first polarizer, said first Faraday cell, the Faraday cell of said polarization state detector, and the Faraday cell of said polariza-

tion state detector.

Fig.1

## Fig.2

## Fig.3

Fig.4

## Fig.5

## Fig.6

$$I = a_{sin}(2\pi ft\psi)$$

## Fig.7

## Fig.8

## Fig.9

```
20 →  ┌──────────┐    ┌──────────┐    ┌──────────┐    ┌──────────┐    ┌──────────┐
       │   1st    │ →  │ Detecting│ →  │Modulating│ →  │   2nd    │ →  │Arithmetic│
       │ polarizer│    │ Faraday  │    │ Faraday  │    │ polarizer│    │ section  │
       │          │    │   cell   │    │   cell   │    │          │    │          │
       └──────────┘    └──────────┘    └──────────┘    └──────────┘    └──────────┘
          17              18              1               2               40
                          ↑               ↑
                          │               │ Im
                    ┌──────────┐
                    │Integrator│  43
                    └──────────┘
                          ↑
                          │ I
```

## Fig.10

EP 0 598 356 A2

*Fig.11*

*Fig.12*

13

Fig. 13

Fig.14 PRIOR ART